Europäisches Patentamt

European Patent Office

Office européen des brevets

(19)

(11) **EP 0 848 524 A1**

## (12) DEMANDE DE BREVET EUROPEEN

(43) Date de publication:
17.06.1998 Bulletin 1998/25

(51) Int. Cl.$^6$: **H04L 27/34**

(21) Numéro de dépôt: 97203747.7

(22) Date de dépôt: 29.11.1997

(84) Etats contractants désignés:
AT BE CH DE DK ES FI FR GB GR IE IT LI LU MC NL PT SE
Etats d'extension désignés:
AL LT LV MK RO SI

(30) Priorité: 10.12.1996 FR 9615160

(71) Demandeur:
Philips Electronics N.V.
5621 BA  Eindhoven (NL)

(72) Inventeurs:
• Chouly, Antoine
75008 Paris (FR)
• Brajal, Américo
75008 Paris (FR)
• Gianella, David
75008 Paris (FR)

(74) Mandataire: Landousy, Christian
Société Civile S.P.I.D.
156, Boulevard Haussmann
75008 Paris (FR)

(54) **MAQ à codage perforé en trellis, avec décodage itératif**

(57)    Le système de transmission numérique applique aux données d'entrée un code convolutif systématique perforé pour générer un code produit en blocs avec fermeture du treillis par ajout de données redondantes. Les données ainsi codées sont ensuite attribuées à des symboles d'une modulation d'amplitude en quadrature.

A la réception, les moyens de décodage effectuent un décodage itératif en calculant des fiabilités de décisions dures afin de délivrer des décisions douces sur les symboles de sortie.

L'invention concerne également un procédé de protection de données mis en oeuvre dans un tel système.

Application: Systèmes de transmission numérique pour la télévision par câble, par satellite. Systèmes pour la diffusion terrestre de données ou pour la transmission sur lignes téléphoniques.

FIG.1

## Description

L'invention concerne un système de transmission numérique à protection de données d'entrée, comportant des moyens de codage desdites données et des moyens de décodage itératif, les moyens de codage comportant un premier sous-ensemble pour effectuer un codage convolutif systématique en treillis permettant le décodage itératif et un second sous-ensemble pour attribuer les données codées à des symboles d'une modulation numérique.

L'invention concerne également un procédé de protection de données d'entrée mis en oeuvre dans un tel système de transmission numérique.

Le système peut être utilisé pour la transmission numérique pour la télévision par câble, par satellite, pour la diffusion terrestre, pour la transmission sur lignes téléphoniques ou autres.

On connaît des systèmes de protection sélective combinant un codage convolutif avec une modulation numérique. En particulier, pour augmenter les performances d'un tel système en termes de taux d'erreurs binaires, une nouvelle classe de codes convolutifs appelés turbo-codes a été décrite dans le document intitulé: "Near Shannon limit error-correcting coding and decoding: Turbo-codes (1), C. BERROU, A. GLAVIEUX, P. THITIMAJSHIMA, Proceeding of ICC'93, Genève, Mai 1993, pages 1064-1071. Ces turbo-codes ont des performances, exprimées en taux d'erreurs binaires, proches des limites théoriques prévues par Shannon. Il s'agit de codes convolutifs concaténés en parallèle. Ces codes convolutifs sont basés sur des codes récursifs perforés systématiques c'est-à-dire qui découlent de codes de rendement 1/2 pour lesquels un bit d'entrée donne naissance à deux bits de sortie, la perforation étant appliquée aux bits eux-mêmes. La concaténation quant à elle, est réalisée par un entrelacement approprié des données renfermant l'information.

A la réception, le décodage itératif dit décodage turbo, consiste à décoder plusieurs fois les symboles reçus pour améliorer les performances du système en termes de taux d'erreurs binaires. Les décodages itératifs successifs sont effectués par un unique décodeur de Viterbi à décision douce. Ce décodeur est différent d'un décodeur de Viterbi classique qui effectue une décision dure. Dans ce document les décisions douces en sortie du décodeur délivrent un taux de fiabilité d'une décision dure c'est-à-dire une probabilité de décision correcte. Le décodeur est ensuite suivi d'un désentrelacement des données de sortie.

Mais l'utilisation de turbo-codes suivis d'un décodage itératif révélés dans ce document ne supprime pas les limitations des codes systématiques perforés issus de codes de rendement 1/2 surtout lorsque ces derniers sont appliqués séparément de la modulation numérique avec laquelle ils coopèrent. En particulier, un inconvénient de ces codes est qu'ils ne sont adaptés qu'à des modulations à faible efficacité spectrale (inférieure ou égale à deux bits/s/Hz) comme les modulations de phase MDP2 et MDP4. Il leur correspond un débit binaire égal au maximum à deux fois la bande utilisée. Pour augmenter le débit pour une bande occupée fixée, on pourrait chercher à utiliser des modulations à grande efficacité spectrale du type modulation d'amplitude en quadrature (MAQ). Mais l'utilisation des codes convolutifs perforés décrits, juxtaposés à des modulations MAQ, ne donne pas des performances optimales, car ces codes ont été conçus indépendamment de la modulation.

Le but de l'invention est donc d'accroître les performances de tels systèmes de transmission numérique en garantissant un fonctionnement correct du système avec un rapport signal/bruit minimal tout en améliorant leur efficacité spectrale.

Ce but est atteint avec un système dans lequel le premier sous-ensemble met en oeuvre un codage convolutif systématique en treillis de rendement M/2M où M est un entier supérieur à 1 auquel il ajoute une perforation appliquée aux symboles pour obtenir un rendement de codage plus élevé, le code convolutif systématique perforé ainsi obtenu étant utilisé pour générer un code produit en blocs avec fermeture du treillis par ajout de données redondantes, le code produit étant formé de composantes générées par codage de lignes et de colonnes d'une matrice groupant les données codées par le code convolutif systématique perforé, le second sous-ensemble combinant le code produit avec une modulation d'amplitude en quadrature à $2^{2M}$ états, le décodage itératif étant un décodage en blocs.

Pour générer le code produit ainsi que la redondance ajoutée à partir des codes convolutifs systématiques, les moyens de codage peuvent comporter des moyens, dits machine d'états, définissant des états de sortie, des symboles de redondance à partir d'états d'entrée et des symboles d'information.

Préférentiellement la machine d'états est couplée à une table de lecture pour déterminer les symboles de redondance du code convolutif et les symboles servant à la fermeture du treillis.

L'invention concerne aussi un procédé de protection de données d'entrée mis en oeuvre dans un tel système de transmission numérique, le procédé comportant une phase de codage desdites données et une phase de décodage itératif, la phase de codage comportant une première étape de codage convolutif systématique en treillis permettant le décodage itératif combinée à une seconde étape d'attribution des données codées à des symboles d'une modulation numérique, caractérisé en ce que lors de la première étape le codage convolutif systématique en treillis présente un rendement de codage M/2M, où M est un entier supérieur à 1, le codage étant soumis à une perforation appliquée aux symboles pour obtenir un rendement de codage plus élevé, les codes convolutifs systématiques perforés ainsi obtenus étant utilisés pour générer un code produit en blocs avec fermeture du treillis par ajout de données redondantes, le code produit étant formé de composantes générées par codage de lignes et de colonnes d'une matrice groupant les données codées par le code convolutif systématique perforé, la seconde étape combinant le code produit avec une modulation d'amplitude en quadrature à $2^{2M}$ états, le décodage itératif étant un décodage en blocs.

Il s'agit d'un codage convolutif de rendement M/2M (préférentiellement un rendement 2/4) perforé pour atteindre un rendement plus élevé (préférentiellement un rendement 7/8). Ce codage est combiné avec une modulation numérique à $2^{2M}$ états (respectivement MAQ16), le codage et la perforation étant combinés pour fournir des performances optimales. Selon cet exemple (M=2, rendement 7/8), un tel codage est obtenu en traitant un train binaire dans lequel on prend, deux par deux, des bits (dits bits d'entrée) pour les coder en quatre bits (dits bits de sortie) qui sont à leur tour perforés pour obtenir 16 bits de sortie pour 14 bits d'entrée. Les 2M bits (respectivement les quatre bits) de sortie sélectionnent deux symboles à $2^M$ niveaux (respectivement à quatre niveaux {+1, -1, +3, -3}) c'est-à-dire deux symboles réels de la modulation d'amplitude à $2^M$ niveaux avec M bits de sortie par symbole (respectivement à quatre niveaux 4-AM avec deux bits de sortie par symbole). Après le codeur, on applique une perforation aux deux symboles de sortie de la modulation $2^M$-AM (respectivement 4-AM ) et non pas aux bits. La perforation est définie par une matrice de perforation. Le codage produit est réalisé en appliquant le codage convolutif systématique perforé aux lignes et aux colonnes d'une matrice contenant les bits d'information avec fermeture du treillis pour chaque ligne et chaque colonne. Ensuite, les symboles 4-AM issus de la matrice après le codage produit sont combinés 2 par 2 pour générer des symboles MAQ16. Les données codées sont ensuite transmises par une porteuse selon les techniques habituelles.

Pour permettre d'effectuer le décodage turbo à la réception, le codage produit doit être systématique. Pour cela, il faut utiliser des codes convolutifs systématiques c'est-à-dire qu'après codage les symboles d'information en entrée se retrouvent sans changement en sortie.

Les codes convolutifs de rendement M/2M, par exemple 2/4 décrits ci-après, sont conçus de telle façon qu'après perforation ils soient optimaux, c'est-à-dire qu'ils donnent le taux d'erreurs le plus faible pour un rapport signal/bruit donné et ceci spécifiquement pour la modulation 4-AM ou MAQ16.

On obtient ainsi un système ayant les performances optimales à la fois en rapport signal/bruit et en efficacité spectrale en combinant une structure de codeur réalisant de manière optimale le codage convolutif systématique de rendement 2/4 avec une matrice de perforation réalisant de manière optimale la perforation. La structure et la matrice sont optimisées pour opérer ensemble. La matrice de perforation optimale dépend du rendement final recherché.

Selon l'invention, il s'agit bien d'un codage produit utilisant un codage convolutif systématique combiné avec une modulation d'amplitude en quadrature et non pas d'une juxtaposition.

Ce système comporte plusieurs avantages.

Par rapport au système de l'art antérieur utilisant des codes perforés binaires avec une modulation de phase MDP4, on dispose d'une capacité de transmission deux fois plus élevée (efficacité spectrale entre deux et quatre bits/s/Hz);

Le système a une complexité matérielle faible puisqu'un seul décodeur à décision douce est nécessaire pour effectuer le décodage itératif du code produit.

Les codes utilisés sont préférentiellement des codes convolutifs systématiques de rendement 2/4, avec deux bits en entrée et quatre bits en sortie. La fonction qui génère les quatre bits de sortie en fonction des bits d'entrée et de l'état (mémoire) du codeur a été optimisée en présence de la modulation MAQ16.

La perforation est appliquée sur des symboles 4-AM c'est- à-dire sur des symboles réels prenant quatre valeurs possibles (+1, - 1, +3, -3) et non sur des bits comme c'est le cas de la perforation de l'art antérieur;

Les codes convolutifs perforés, ayant préférentiellement un rendement 7/8, sont choisis de telle manière que la distance euclidienne minimale de ces codes combinés avec la modulation MAQ16 soit maximale afin d' améliorer les performances. Ceci fait ressortir la combinaison du codage avec la modulation.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent:

Figure 1 : un schéma d'un système de transmission numérique en bande de base selon l'invention.

Figure 2 : un schéma général d'un codeur permettant de générer le code produit.

Figure 3 : un schéma général d'un codeur convolutif systématique de rendement 2/4 combiné avec un modulation 4-AM avec codage par perforation.

Figure 4 : un schéma d'un exemple particulier de réalisation du codeur pour un code de rendement 2/4.

Figure 5 : un schéma d'un exemple particulier d'un codeur à 16 états pour obtenir un codage convolutif systématique de rendement 2/4.

Figure 6 : une représentation du treillis d'un code de rendement 2/4 perforé pour fournir un rendement 7/8.

Figure 7 : un codeur pour coder également les symboles de redondance.

Figure 8 : un schéma général d'un décodeur selon l'invention.

Figure 9 : un organigramme des différentes étapes du décodage.

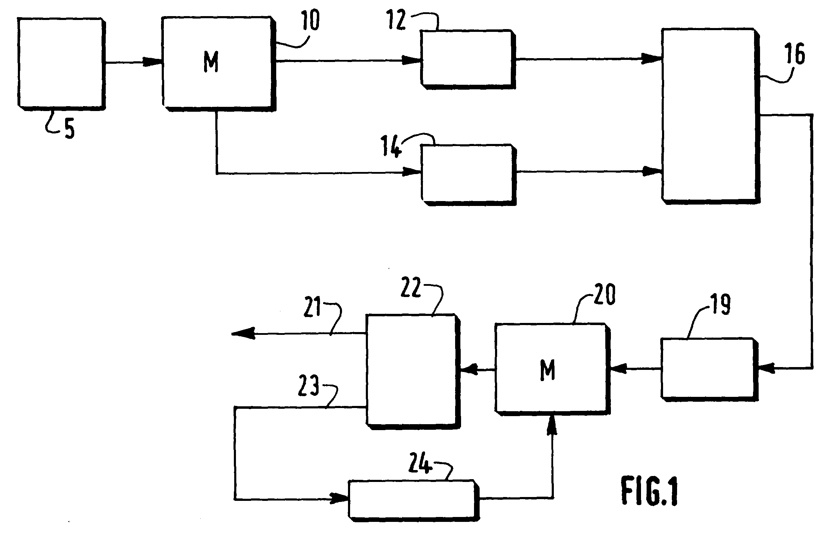

La figure 1 représente un schéma d'un système de transmission numérique en bande de base selon l'invention. Les données d'entrée à protéger issues d'une source 5 sont organisées en matrice par exemple en les stockant dans un mémoire 10 formée de lignes et de colonnes qui peuvent être adressées séparément. Le système comporte des moyens 12 de codage de lignes et des moyens 14 de codage de colonnes. L'un et l'autre délivrent des données qui sont affectées à des symboles d'une modulation numérique 4-AM. Un organe d'attribution 16 transforme les symboles 4-AM en symboles MAQ16. Il s'agit d'un groupement 2 par 2 des symboles 4-AM en sortie du codage produit.

Ces symboles sont transmis selon les techniques habituelles à travers un canal 19 vers des moyens de réception. Les données reçues passent dans des moyens 20 de stockage temporaire (par exemple une mémoire) qui permettent d'effectuer le traitement en boucle décrit ci-après. En sortie des moyens de stockage 20, les données entrent dans un décodeur de Viterbi 22 qui présente deux sorties, une sortie 21 à décision dure qui délivre les symboles estimés obtenus pour chaque itération et une sortie 23 à décision douce qui est rebouclée sur la mémoire 20 à travers un entrelaceur de données 24. Les symboles estimés sont de plus en plus fiables au fur et à mesure que le traitement itératif est répété. En moyenne, cette amélioration, mesurée en taux d'erreurs, est obtenue après quatre à cinq itérations.

$$
\begin{array}{|c|c|c|}
\hline
\begin{array}{l} S_{11}\ldots S_{1,j}\ldots S_{1,7N} \\ \ldots\ldots\ldots \\ S_{i1}\ldots S_{i,j}\ldots S_{i,7N} \\ \ldots\ldots\ldots \\ S_{7N,1}\ldots S_{7N,j}\ldots S_{7N,7N} \end{array} &
\begin{array}{l} R_{11}\ldots R_{1,j}\ldots R_{1,7N} \\ \ldots\ldots\ldots \\ R_{i1}\ldots R_{i,j}\ldots R_{i,7N} \\ \ldots\ldots\ldots \\ R_{7N,1}\ldots R_{7N,j}\ldots R_{7N,7N} \end{array} &
\begin{array}{l} TR_{11}, TR_{12} \\ \ldots\ldots\ldots \\ TR_{i,1}, TR_{i,2} \\ \ldots\ldots \\ TR_{7N,1}, TR_{7N,2} \end{array} \\
\hline
\end{array}
$$

$$
\begin{array}{|l|}
\hline
C_{11}\ldots C_{1,j}\ldots C_{1,7N} \\ \ldots\ldots\ldots \\ C_{i1}\ldots C_{i,j}\ldots C_{i,7N} \\ \ldots\ldots\ldots \\ C_{N,1}\ldots C_{N,j}\ldots C_{N,7N} \\
\hline
TC_{11}\ldots TC_{1,j}\ldots TC_{1,7N} \\ TC_{21}\ldots TC_{2,j}\ldots TC_{2,7N} \\
\hline
\end{array}
$$

TABLEAU I

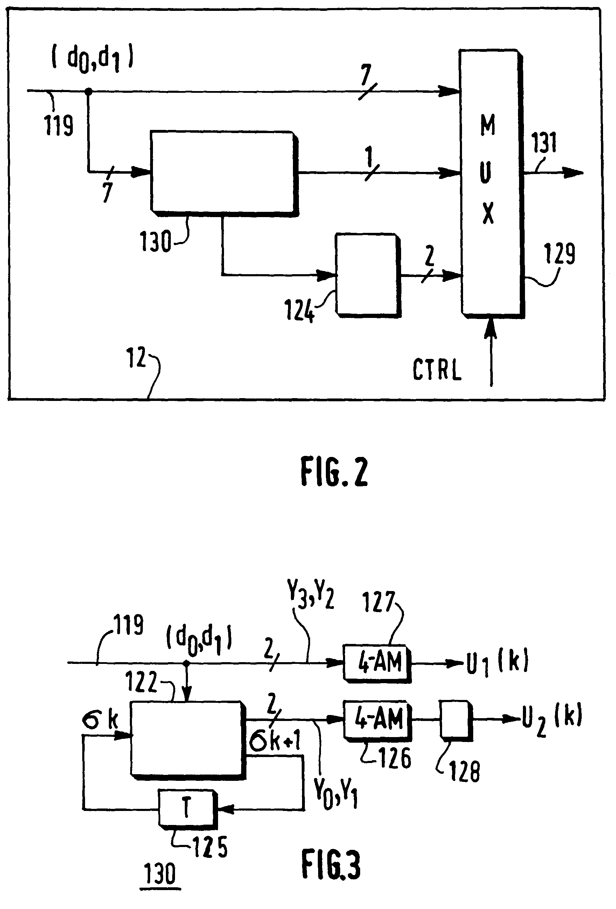

Pour obtenir le code produit, le codage d'une ligne de la matrice est effectué de la façon suivante (figure 2) par le codeur de ligne. Considérons à titre d'exemple un code convolutif systématique perforé de rendement 7/8 (codeur 130). Avec 7 symboles d'information utile (Tableau I), on génère 8 symboles comportant les 7 symboles utiles (code convolutif systématique) plus un symbole de redondance. Considérons la première ligne de la matrice constituée de N blocs de 7 symboles d'information soit 14 bits qui sont:

$(S_{11},\ldots S_{17}),(S_{18},\ldots S_{1,14}),\ldots,(S_{1,7(N-1)+1},\ldots S_{1,7N})$ .

Pour chaque bloc, on calcule le symbole de redondance (soit 2 bits) du code convolutif systématique perforé (figure 2). Le bloc 1 fournit $R_{11}$, le bloc 2 fournit $R_{12}$ et ainsi de suite jusqu'au bloc N qui fournit $R_{1,N}$.

On suppose que l'état initial du codeur est égal à zéro. Après avoir généré $R_{1,N}$ le codeur est à l'état $\sigma(N)$. On ferme le treillis, en forçant l'état du treillis à zéro en générant 2 symboles d'information $TR_{11}$ et $TR_{12}$ (pour un code à 16 états) correspondant à 2 transitions dans le treillis du code convolutif de telle façon qu'après ces 2 transitions on arrive à l'état $\sigma=0$. Pour un code ayant plus d'états, il faut utiliser plus de symboles de fermeture du treillis. Les symboles $TR_{11}$ et

$TR_{12}$ sont fonction de l'état du treillis $\sigma(N)$ après le codage d'une ligne et sont générés par une table adressée par $\sigma(N)$.

Le codeur de ligne 12 opère de la manière suivante. Les symboles d'entrée do, d1 entrent dans le codeur 130 de rendement 7/8 qui délivre un symbole de redondance pour un bloc de 7 symboles d'information. Un multiplexeur 129 effectue la mise en série des symboles. Pour cela, il délivre sur sa sortie 131, dans l'ordre, des groupes de 8 symboles, chaque groupe étant formé par les 7 symboles d'information et le symbole de redondance correspondant à ce bloc. Le multiplexeur délivre ensuite tous les groupes de 8 symboles consécutifs. Lorsque tous les groupes sont extraient, il extrait les 2 symboles de fermeture du treillis délivrés par un organe 124 de détermination des symboles de fermeture.

Les symboles $TR_{11}$ et $TR_{12}$ sont formés de deux symboles ayant chacun deux bits. Le tableau II suivant donne les valeurs, exprimées en notation décimale, prises par ces deux bits en fonction de l'état du codeur pour le code à 16 états. Les valeurs des bits de chaque symbole sont données également en notation décimale pour faciliter l'écriture du tableau.

TABLEAU II

| $\sigma(N)$ (binaire) | $\sigma(N)$ (décimal) | TR11,TR12 (décimal) | $\sigma(N+1),\sigma(N+2)$ décimal) |
|---|---|---|---|
| 0000 | 0 | (0,0) | 0,0 |
| 1000 | 8 | (2,2) | 4,0 |
| 0010 | 2 | (2,1) | 1,0 |
| 1010 | 10 | (0,3) | 5,0 |
| 0100 | 4 | (2,0) | 0,0 |
| 1100 | 12 | (0,2) | 4,0 |
| 0110 | 6 | (0,1) | 1,0 |
| 1110 | 14 | (2,3) | 5,0 |
| 0001 | 1 | (1,0) | 0,0 |
| 1001 | 9 | (3,2) | 4,0 |
| 0011 | 3 | (3,1) | 1,0 |
| 1011 | 11 | (1,3) | 5,0 |
| 0101 | 5 | (3,0) | 0,0 |
| 1101 | 13 | (1,2) | 4,0 |
| 0111 | 7 | (1,1) | 1,0 |
| 1111 | 15 | (3,3) | 5,0 |

Les symboles TR11 et TR12 peuvent être stockés dans une table de lecture 124 adressée par l'état du codeur.

Le même traitement est effectué pour les autres lignes.

De la même manière, un traitement semblable est réalisé pour les colonnes (codeur de colonnes 14). Le premier bloc de la première colonne est formé des symboles:

$S_{11},S_{21}.....S_{7N,1}$. A chaque bloc va correspondre un symbole de redondance, par exemple au premier bloc va correspondre le symbole $C_{11}$ et au dernier bloc va correspondre le symbole $C_{N,1}$. Les symboles de redondance de fermeture du treillis vont être pour la première colonne les symboles $TC_{11}$ et $TC_{12}$. L'ensemble des données formées par les symboles d'information initiale, les symboles de redondance de codage ligne et de codage colonne et les symboles de fermeture du treillis forment le code produit. Le codage produit réalisé suivant le schéma de la figure 1 donne une matrice suivant le tableau I.

Une ligne de ce code produit va former un bloc de symboles qui sert à coder des symboles d'une modulation 4-AM. Comme les symboles d'information initiale restent les mêmes dans le code produit qu'ils soient lus en ligne ou en colonne, pour utiliser les colonnes du code produit il est inutile d'utiliser une seconde fois les symboles d'information initiale. Seules donc les symboles de redondance des colonnes du code produit sont utilisés pour coder (codeur de colonnes 14) des symboles d'une modulation 4-AM. Les symboles 4-AM issus des lignes et des colonnes du code produit servent à coder une modulation MAQ16 dans l'organe d'attribution 16.

Pour accroître les performances du système, il est possible de coder aussi les symboles de redondance qui viennent d'être calculés. Dans ce cas, on code la matrice d'information de dimensions 7Nx7N suivant les lignes et les colonnes pour obtenir la redondance de ligne (symboles $R_{ij}$ et $TR_{ij}$) et la redondance colonne (symboles $C_{ij}$ et $TC_{ij}$) de la même manière que cela vient d'être décrit. Ainsi on code en colonne la redondance ligne et en ligne la redondance colonne afin d'accroître les performances du système. Ainsi par exemple, on va coder le bloc de 7N symboles $(R_{11},...R_{7N,1})$ pour générer les N symboles de redondance colonne $(RC_{11},...RC_{N,1})$ provenant de la redondance du code 7/8 et les deux symboles de redondance $(RCT_{11}, RCT_{21})$ de fermeture du treillis. On fait de même pour les autres colonnes de la redondance ligne $(R_{1,j}...R_{7N,j})$ pour j=1,...N et les 2 colonnes $(TR_{11}...TR_{7N,1})$ et $(TR_{12},...TR_{7N,2})$. On code aussi les lignes de la redondance colonnes c'est-à-dire les lignes $(C_{i,1}...C_{i,7N})$ pour i=1,...N et les 2 lignes $(TC_{11},...TC_{1,7N}$ et $TC_{21},...TC_{2,7N})$.

On obtient ainsi la matrice suivante:

| $S_{11}\ldots S_{1,j}\ldots S_{1,7N}$ <br> $S_{i1}\ldots S_{i,j}\ldots S_{i,7N}$ <br> $S_{7N,1}\ldots S_{7N,j}\ldots S_{7N,7N}$ | $R_{11}\ldots R_{1,j}\ldots R_{1,7N}$ <br> $R_{i1}\ldots R_{i,j}\ldots R_{i,7N}$ <br> $R_{7N,1}\ldots R_{7N,j}\ldots R_{7N,7N}$ | $TR_{11}, TR_{12}$ <br> $TR_{i,1}, TR_{i,2}$ <br> $TR_{7N,1}, TR_{7N,2}$ |
|---|---|---|
| $C_{11}\ldots C_{1,j}\ldots C_{1,7N}$ <br> $C_{i1}\ldots C_{i,j}\ldots C_{i,7N}$ <br> $C_{N,1}\ldots C_{N,j}\ldots C_{N,7N}$ | $RC_{11}\ldots RC_{1,j}\ldots RC_{1,N}$ <br> $RC_{i1}\ldots RC_{i,j}\ldots RC_{i,N}$ <br> $RC_{N,1}\ldots RC_{N,j}\ldots RC_{N,N}$ | $TRC_{11}, TRC_{12}$ <br> $TRC_{i,1}, TRC_{i,2}$ <br> $TRC_{N,1}, TRC_{N,2}$ |
| $TC_{11}\ldots TC_{1,j}\ldots TC_{1,7N}$ <br> $TC_{21}\ldots TC_{2,j}\ldots TC_{2,7N}$ | $RCT_{11}\ldots RCT_{1,j}\ldots RCT_{1,N}$ <br> $RCT_{21}\ldots RCT_{2,j}\ldots RCT_{2,N}$ | $TRCT_{11}, TRCT_{12}$ <br> $TRCT_{21}, TRCT_{22}$ |
| | $CR_{11}\ldots CR_{1,j}\ldots CR_{1,N}$ <br> $CR_{i,1}\ldots CR_{i,j}\ldots CR_{i,N}$ <br> $CR_{N,1}\ldots CR_{N,j}\ldots CR_{N,N}$ | $CRT_{11}, CRT_{12}$ <br> $CRT_{i,1}, CRT_{i,2}$ <br> $CRT_{N,1}, CRT_{N,2}$ |
| | $TCR_{11}\ldots TCR_{1,j}\ldots TCR_{1,N}$ <br> $TCR_{2,1}\ldots TCR_{2,j}\ldots TCR_{2,N}$ | $TCRT_{11}, TCRT_{12}$ <br> $TCRT_{21}, TCRT_{22}$ |

TABLEAU III

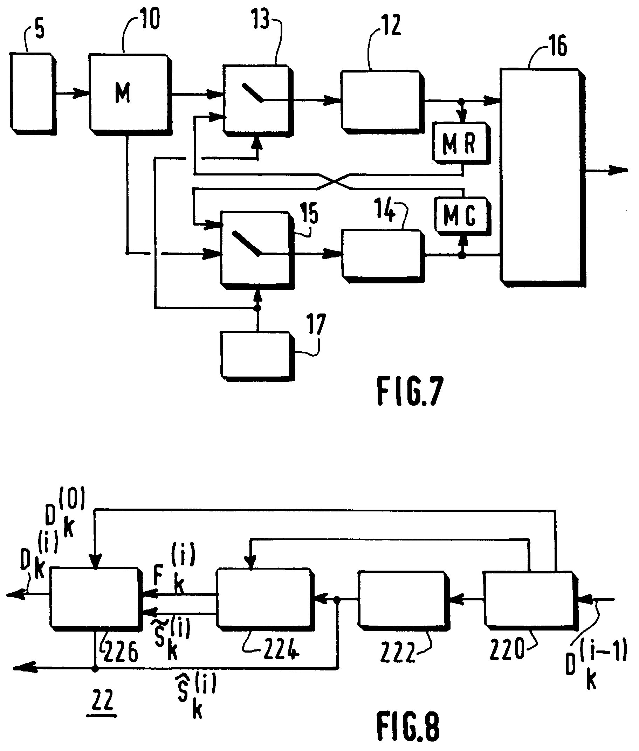

Le schéma du codeur permettant de faire ce double codage de la redondance est représenté sur la figure 7. Les mêmes éléments que ceux de la figure 1 sont représentés avec les mêmes repères. Dans le cas de l'exemple considéré, la mémoire 10 contient 49 $N^2$ symboles. Une autre mémoire MR contient les 7N (N+2) symboles de redondance ligne (symboles $R_{ij}$, $TR_{ij}$) Une autre mémoire MC contient les 7N(N+2) symboles de redondance colonne (symboles $C_{ij}$ et $TC_{ij}$). Les mémoires MR et MC sont chargées après avoir fini le codage en ligne et en colonne de M. Ensuite, on effectue le codage MR suivant les colonnes et le codage MC suivant les lignes pour générer les $(N+2)^2$ symboles 4-AM $(RC_{ij}, TRC_{ij}, RCT_{ij}$ et $TRCT_{ij})$ et les $(N+2)^2$ symboles 4-AM $(CR_{ij}, CRT_{ij}, TCR_{ij},$ et $TCRT_{ij})$ respectivement. Des permutateurs 13 et 15 assurent le déroulement des opérations sous le contrôle d'un contrôleur 17.

Finalement tous les symboles 4-AM formé pour chaque mot de code du code produit des tableaux I ou III sont regroupés 2 par 2 et transmis sur le canal sous la forme de symboles complexes de la constellation MAQ16 (suivant un ordre bien défini).

Le rendement du code produit sans codage de la redondance est égal à:

$$\rho_1 = \frac{7N}{9N+4}.$$

L'efficacité spectrale est alors égale à 4 fois ce rendement. L'efficacité spectrale est de 3 bits/s/Hz pour N=12. Avec un double codage de la redondance le rendement du code produit devient égal à:

$$\rho_2 = \frac{49N^2}{65N^2+36N+8}.$$

Ainsi avec N=12 on obtient une efficacité spectrale de 2,88 bits/s/Hz. Il y a une perte d'efficacité spectrale à coder la redondance de 0,12 bit/s/Hz mais on accroît les performances du système.

L'invention se rapporte à des données d'information soumises à un codage convolutif systématique. La figure 3 donne un mode de réalisation du codeur convolutif systématique perforé qui fait alors aussi partie du codeur de lignes et du codeur de colonnes de la figure 1. La figure 3 montre comment réaliser le codage 7/8 par la mise en cascade d'un code 2/4 et d'une perforation du code. Les symboles d'information d'entrée $(d_0(k),d_1(k))$ à coder arrivent par la connexion 119. Pour générer un code convolutif systématique de rendement 2/4 le traitement est effectué sur des blocs de 2 bits. Ces deux bits restent inchangés $Y_3, Y_2$ pour coder une modulation 4-AM dans les moyens de modulation 127 qui délivrent les symboles d'information U1(k). L'affectation des bits Y3,Y2 aux symboles 4-AM est représentée sur le tableau IV.

TABLEAU IV

| $(Y_3, Y_2)$ resp. $(Y_1, Y_0)$ | 00 | 01 | 10 | 11 |
|---|---|---|---|---|
| $U_1$ resp $U_2$ | +3 | +1 | -1 | -3 |

Par ailleurs, les mêmes symboles d'entrée entrent dans une machine d'état 122 qui détermine un état successeur $\sigma_{k+1}$ du décodeur à partir d'un état précédent $\sigma_k$. Un organe de retard 125 assure le décalage temporel d'une durée symbole. La machine d'état 122 délivre deux bits $Y_0$ et $Y_1$ qui servent à coder une modulation 4-AM (bloc 126) (tableau IV) qui sont suivis de moyens 128 pour perforer le code et délivrer les symboles U2 (k).

Pour obtenir un code de rendement supérieur à M/2M, les symboles de redondance U2 doivent subir une perforation (figure 3). Pendant la procédure de perforation, on interdit la transmission de certains symboles de redondance en fonction d'une matrice (appelée matrice de perforation) et ceci périodiquement. La perforation va consister à ne pas transmettre tous les symboles U2 à certains moments. Un zéro dans la matrice signifie que le symbole correspondant n'est pas transmis. A titre d'exemple considérons la perforation du code de rendement 2/4 permettant d'obtenir en sortie un code perforé de rendement 7/8.

A partir de 7 symboles d'information (d1, d0) on transmet les mêmes symboles U1 (symboles 4-AM) et 1 symbole de redondance U2 qui correspond aux bits de redondance (Y3, Y2) générés lors du codage du 7ème (dernier) symbole du bloc par le code convolutif de rendement 2/4. La matrice de perforation du code à 16 états est:

$$A = \begin{vmatrix} 1 & 1 & 1 & 1 & 1 & 1 & 1 \\ 0 & 0 & 0 & 0 & 0 & 0 & 1 \end{vmatrix}.$$

La première ligne de la matrice concerne le symbole U1 et la seconde ligne concerne le symbole U2.

Au lieu de transmettre 4 bits pour chaque colonne de la matrice, seulement 2 bits sont transmis pour les colonnes contenant un zéro dans la matrice. Ainsi avec la matrice A la perforation permet de ne transmettre, pendant 7 périodes, que 8 symboles sur les 14 générés par le code mère de rendement 2/4.

Ainsi le rendement du code perforé devient plus élevé que celui du code non perforé, c'est-à-dire que pour le même nombre de bits d'information (à l'entrée du codeur) le nombre de bits transmis est plus petit que celui du code non perforé.

A un instant kT, les bits $(Y_0, Y_1)$, $(Y_2, Y_3)$ servent respectivement à sélectionner dans les dispositifs 126, 127 les symboles U1 et U2 respectivement de la modulation d'amplitude 4-AM.

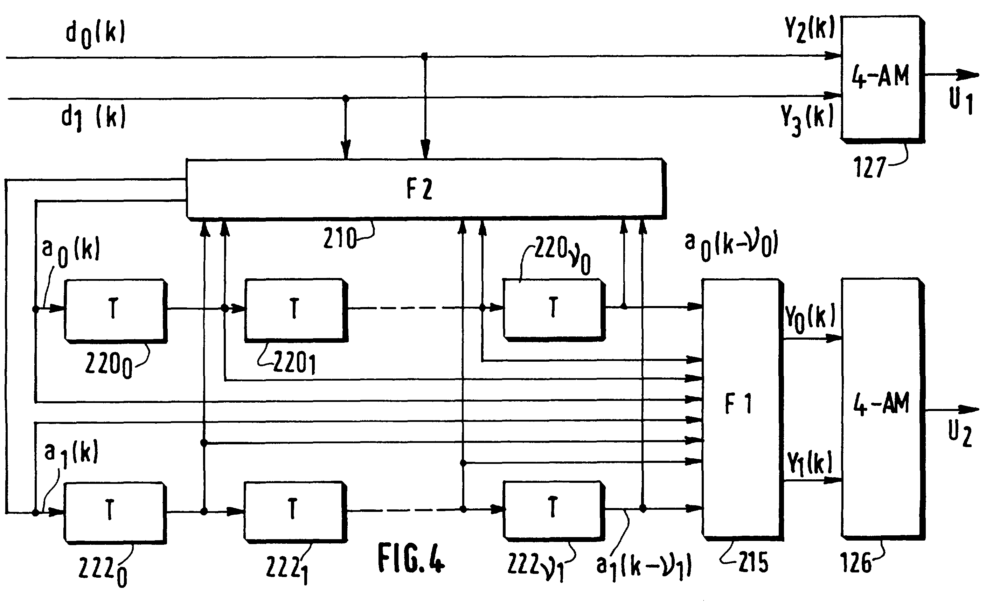

La figure 4 est un schéma particulier relatif à un codeur convolutif systématique de rendement 2/4 pouvant remplacer la machine d'états 122. Les symboles d'entrée $d_0(k)$ et $d_1(k)$ entrent dans un dispositif 210 qui applique une fonction linéaire F2 lequel délivre deux symboles $a_0(k)$ et $a_1(k)$. Ces symboles entrent respectivement dans deux chaînes de cellules à décalage $220_0$, $220_1$,...$220_{v0}$ et $222_0$, $222_1$,...$222_{v1}$ qui délivrent en sortie de leur dernière cellule respectivement les symboles retardés $a_0(k\text{-}v0)$ et $a_1(k\text{-}v1)$. Les sorties de toutes les cellules à retard entrent dans le dispositif 210 appliquant la fonction linéaire F2 et dans un dispositif 215 appliquant une fonction linéaire F1. Le dispositif 215 reçoit aussi les symboles a0(k) et a1(k). Le dispositif 215 délivre les symboles codés $Y_0(k)$ et $Y_1(k)$ qui entrent dans les moyens de modulation 126 qui délivrent le symbole U2.

A titre d'exemple, un code convolutif systématique est obtenu avec le schéma de la figure 4 pour lequel les fonction F1 et F2 sont les suivantes:

- fonction F1:

$$Y_2(k)=d_0(k)$$

$$Y_3(k)=d_1(k)$$

$$Y_0(k)=\sum_{l=0}^{v_0} h_{00}^l\ a_0(k\text{-}l)\oplus\sum_{l=0}^{v_1} h_{10}^l\ a_1(k\text{-}l)$$

$$Y_1(k)=\sum_{l=0}^{v_0} h_{01}^l\ a_0(k\text{-}l)\oplus\sum_{l=0}^{v_1} h_{11}^l\ a_1(k\text{-}l)$$

où le symbole $\Sigma$ désigne une somme modulo 2.
- fonction F2:

$$a_0(k)=d_0(k)\oplus\sum_{l=1}^{v_0} h_{02}^l\ a_0(k\text{-}l)\oplus\sum_{l=0}^{v_1} h_{12}^l\ a_1(k\text{-}l)$$

$$a_1(k)=d_1(k)\oplus\sum_{l=0}^{v_0} h_{03}^l\ a_0(k\text{-}l)\oplus\sum_{l=1}^{v_1} h_{13}^l\ a_1(k\text{-}l)$$

avec $(h_{03}^0, h_{12}^0)\neq(1,1)$
le symbole $\Sigma$ désignant une somme modulo 2, le signe $\oplus$ étant un ou-exclusif. Les coefficients $h_{ij}^l$ sont des coefficients binaires et ($a_0(k\text{-}l)$, $a_1(k\text{-}l')$) pour $l=1,...,v_0$ et $l'=1,...,v_1$ représentent l'état $\sigma_k$ du codeur à l'instant k.

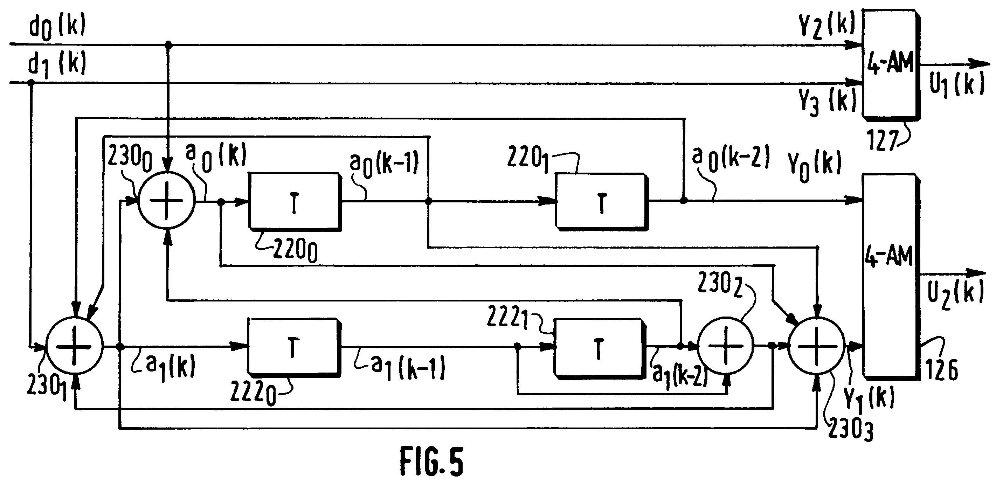

La figure 5 est un cas particulier de la figure 4 pour laquelle le nombre de cellules à retard est limité à $v_0 = v_1 =2$ c'est-à-dire pour un code 2/4 à 16 états. Les fonctions F1 et F2 sont réalisées à l'aide de cellules de sommation $230_0$, $230_1$, $230_2$ $230_3$.

- la cellule de sommation $230_0$ reçoit d0(k), a1(k-2) et la sortie de la cellule de sommation $230_1$ et délivre a0(k).
- la cellule de sommation $230_1$ reçoit d1(k), a0(k-1), a0(k-2) et la sortie de la cellule de sommation $230_2$ et délivre a1(k).
- la cellule de sommation $230_2$ reçoit a1(k-1) et a1(k-2).
- la cellule de sommation $230_3$ reçoit a0(k), a0(k-1), a1(k) et la sortie de la cellule de sommation $230_2$.

Les équations qui se rapportent au schéma de la figure 5 sont:

$$Y_2(k)=d_0(k)$$

$$Y_3(k)=d_1(k)$$

$$Y_0(k)=a_0(k\text{-}2)$$

$$Y_1(k)=a_0(k)\oplus a_0(k\text{-}1)\oplus a_1(k)\oplus a_1(k\text{-}1)\oplus a_1(k\text{-}2)$$

avec:

$$a_0(k)=d_0(k)\oplus a_1(k)\oplus a_1(k\text{-}2)$$

$$a_1(k)=d_1(k)\oplus a_0(k\text{-}1)\oplus a_0(k\text{-}2)\oplus a_1(k\text{-}1)\oplus a_1(k\text{-}2)$$

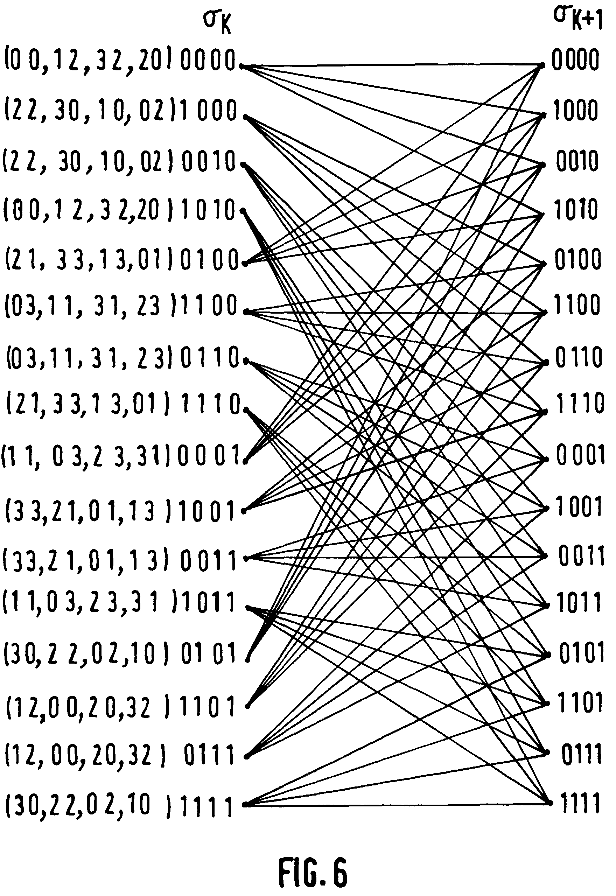

La figure 6 représente le treillis du code convolutif systématique 2/4 décrit ci-dessus. Il donne toutes les transitions possibles du codeur de l'état $\sigma(k)$ à l'état $\sigma(k+1)$. Il s'analyse de la façon suivante.

A partir de l'état $\sigma(k)=[a_0(k\text{-}1),a_0(k\text{-}2),a_1(k\text{-}1),a_1(k\text{-}2)]=[0000]$, le codeur peut transiter vers les 4 états [0000] [1000] [0010] [1010] pour lesquels les transitions génèrent des couples (U1,U2) valant respectivement [00] [12] [32] [20] exprimés en notation décimale. L'ensemble du treillis s'analyse de la même manière.

La figure 8 représente le schéma général d'un étage des moyens 22 de décodage de Viterbi à double décision selon l'invention. Ils comprennent:

- un sous-ensemble 220 de calcul des métriques,
- un décodeur de Viterbi 222 proprement dit qui délivre des décisions dures,
- un sous-ensemble 224 de calcul de fiabilité des décisions,
- un sous-ensemble 226 de calcul de décisions douces.

Le décodage de codes convolutifs systématiques perforés va consister à appliquer un algorithme de décodage à décision douce. Pour simplifier l'exposé, on prendra pour exemple le code convolutif systématique perforé de rendement 7/8. Selon l'exemple particulier décrit pour la ligne d'indice 1 du tableau I, une rangée du code produit est formée par les symboles suivants qui ont été émis à l'émission (pour simplifier l'écriture, l'indice de ligne, ici i=1, est omis dans ce qui suit):

- 7N symboles d'information:
  $S= S_1,...,S_{7N}$
- N symboles de redondance de code:
  $R= R_1,...,R_N$
- 2 symboles de fermeture de treillis:
  $TR= TR_1,TR_2$.

A cause des imperfections du canal de transmission, les symboles reçus $D^{(0)}=(D_1^{(0)},...,D_{8N+2}^{(0)})$ vont présenter des différences par rapport aux symboles émis.

A la réception, on reçoit des symboles complexes correspondant aux symboles MAQ 16 émis après passage dans le canal. Chaque symbole complexe étant considéré comme la suite de 2 symboles réels. Ensuite, on stocke ces symboles réels dans la mémoire 20 (figure 1) suivant une matrice ayant la même structure que la matrice définie à l'émission. Les symboles réels reçus sont rangés dans la matrice en respectant le même ordre que celui utilisé à l'émission. Le processus de décodage est itératif, c'est-à-dire que l'on décode les lignes de la matrice puis les colonnes. Le nombre de lignes ou de colonnes à décoder à chaque itération est égal à 7N dans le cas du tableau I (cas sans codage de la redondance) ou à 8N+2 dans le cas où la redondance est codée. (Tableau III).

Tout d'abord, considérons le décodage itératif à la i-ème itération pour une ligne de la matrice c'est-à-dire un bloc de symboles réels: $D^{(i\text{-}1)}=(D_1^{(i\text{-}1)},...,D_{8N+2}^{(i\text{-}1)})$. Le décodage fournit le bloc: $D^{(i)}=(D_1^{(i)},...,D_{8N+2}^{(i)})$ de 8N+2 symboles réels (sortie douce) qui seront appliqués à l'itération suivante ainsi que la décision optimale $\hat{S}^{(i)}=(\hat{S}_1^{(i)},...,\hat{S}_{8N+2}^{(i)})$. On suppose que les 7N symboles $D_1^{(i\text{-}1)},...,D_{7N}^{(i\text{-}1)}$ correspondent aux symboles d'information, et les N symboles $D_{7N}^{(i\text{-}1)},...,D_{8N}^{(i\text{-}1)}$ correspondent aux symboles de redondance du code 7/8 et les deux symboles $D_{8N+1}^{(i\text{-}1)},D_{8N+2}^{(i\text{-}1)}$ sont les symboles de fermeture du treillis. Les symboles sont traités dans l'ordre suivant:

$$D_1^{(i-1)}, \ldots D_7^{(i-1)}, D_{7N+1}^{i-1};$$

$$D_8^{(i-1)}, \ldots D_{14}^{(i-1)}, D_{7N+2}^{(i-1)};$$

$$D_{7N-6}^{(i-1)}, \ldots D_{7N}^{(i-1)}, D_{8N}^{(i-1)}; \quad \cdot$$

$$D_{8N+1}^{(i-1)}, D_{8N+2}^{(i-1)}$$

Le décodage est effectué en six étapes. L'exposé suivant indique la manière de déduire $D^{(i)}$ de $D^{(i-1)}$.

Au cours de la première étape, le sous-ensemble 220 de calcul des métriques (figure 8) réalise pour chaque symbole $D_k^{(i-1)}$ un calcul de métrique MET(U) pour chaque symbole U de la modulation 4-AM tel que:

$$MET(D_k^{(i-1)}, U) = |D_k^{(i-1)} - U|^2 \text{ pour } k = 1, \ldots 8N+2.$$

Ainsi les métriques qui sont fournies au décodeur de Viterbi sont :

a) pour les transitions du treillis où une perforation a été appliquée (perforation de la redondance) c'est-à-dire les symboles

$$D_1^{(i-1)}, \ldots, D_6^{(i-1)}$$

$$D_8^{i-1}, \ldots, D_{13}^{(i-1)}$$

$$\ldots \ldots$$

$$D_{7l+1}^{(i-1)}, \ldots, D_{7l+6}^{(i-1)}$$

$$\ldots \ldots$$

$$D_{7N-6}^{(i-1)}, \ldots, D_{7N-1}^{(i-1)}$$

$$D_{8N+1}^{(i-1)}, D_{8N+2}^{(i-1)}$$

On fournit pour chaque symbole les 4 métriques des branches du treillis pendant les transitions 1, 2... 6, 8...14, 7l+1...7l+6,...7N-6, ...7N-1, 8N+1, 8N+2.

b) pour les transitions du treillis où il n'y a pas de perforation (toutes les 7 transitions) c'est-à-dire les couples de symboles suivants:

$$D_7^{(i-1)}, D_{7N+1}^{(i-1)}$$

$$D_{14}^{i-1}, D_{7N+2}^{(i-1)}$$

$$\ldots \ldots$$

$$D_{7l+7}^{(i-1)}, D_{7N+l+1}^{(i-1)}$$

$$\ldots \ldots$$

$$D_{7N}^{(i-1)}, D_{8N}^{(i-1)}.$$

Pour chaque couple de symboles on fournit au décodeur de Viterbi les 16 métriques:

$$MET(D_{7I+7}^{(i-1)}, D_{7N+I+1}^{(i-1)}, (U, V)) = MET(D_{7I+7}^{(i-1)}, U) + MET(D_{7N+I+1}^{(i-1)}, V)$$

où U et V sont les 2 symboles 4-AM.

Ces métriques sont les métriques des branches du treillis pendant les transitions numéro 7, 14,...7I,...7N.

Au cours de la seconde étape, le sous-ensemble 222 réalise un décodage conventionnel de Viterbi sur les séquences de symboles reçus. On obtient ainsi la séquence optimale décodée (décision dure) de la ligne:

$$\hat{S}^{(i)} = \hat{S}_1^{(i)}, \dots \hat{S}_{7N}^{(i)}, \hat{S}_{7N+1}^{(i)}, \dots \hat{S}_{8N+2}^{(i)}$$

La séquence des états correspondants aux états décodés est:

$\hat{\sigma}^{(i)} = \hat{\sigma}_0^{(i)}, \dots \hat{\sigma}_{7N+2}^{(i)}$ ce qui correspond à 7N+2 transitions ou branches, avec

$$\hat{\sigma}_0^{(i)} = \hat{\sigma}_{7N+2}^{(i)} = 0,$$

état initial et état final nuls. On mémorise le vecteur de la métrique d'état $M_j^{(i)}(\sigma)$ pour chaque état $\sigma = 0,...15$ et pour chaque instant $j = 1,...N+2$. Finalement on stocke les chemins survivants dans une table. Toutes ces résultats délivrés par le décodeur de Viterbi sont utilisées pour le calcul de la fiabilité.

Au cours de la troisième étape, on calcule la fiabilité de chaque symbole $\hat{S}_k^{(i)}$ de la séquence avec k=1,...8N+2 dans le sous-ensemble 224. La fiabilité caractérise la qualité des symboles décodés (probabilité d'exactitude). Cette fiabilité peut s'écrire:

$$F^{(i)} = F_1^{(i)}, \dots F_{8N+2}^{(i)}.$$

La fiabilité d'un symbole d'ordre k s'écrit:

$$F_k^{(i)} = \log\left[\frac{(\Sigma_{C(\hat{S}^{(i)})} Prob(D^{(i-1)}|C)}{Prob(D^{i-1}|\hat{S}^{(i)})}\right]$$

où $C(\hat{S}_k^{(i)})$ est le jeu de mots-codes. La fiabilité $F_k^{(i)}$ peut s'écrire:

$$F_k^{(i)} = \log\left[\Sigma_{C(\hat{S}_k^{(i)})} \exp\frac{d^2(D^{(i-1)}, \hat{S}^{(i)}) - d^2(D^{(i-1)}, C)}{N_0}\right].$$

En prenant le terme principal de la somme, on peut écrire:

$$F_k^{(i)} \simeq \min_{C(\hat{S}_k^{(i)})}[d^2(C, D^{(i-1)} - d^2(\hat{S}^{(i)}, D^{(i-1)})].$$

Ce minimum correspond au plus proche chemin d'erreur fournissant un symbole 4-AM décodé adjacent au symbole $\hat{S}_k^{(i)}$.

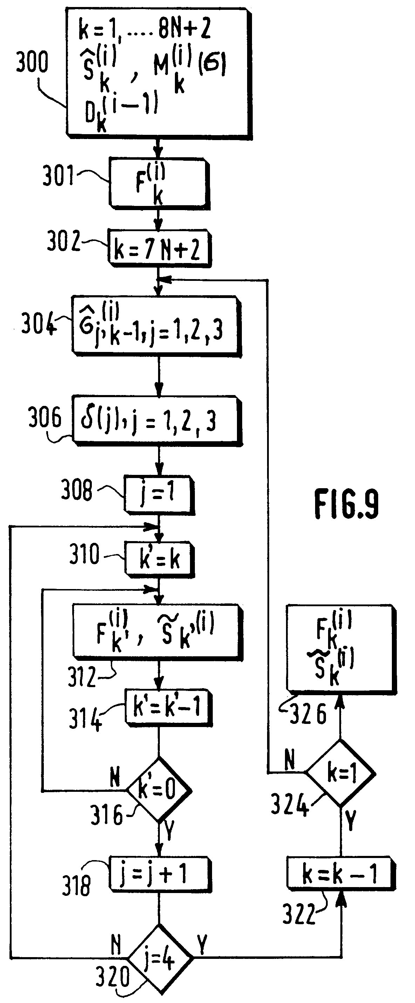

Le calcul de la fiabilité s'opère selon l'algorithme suivant (figure 9). La séquence décodée par Viterbi $\hat{S}_k^{(i)}$ correspond à un chemin dans le treillis de longueur 7N+2. L'algorithme de calcul de la fiabilité $F_k^{(i)}$ de la décision $\hat{S}_k^{(i)}$ pour K=1,...8N+2 est le suivant:

- On part des valeurs de $\hat{S}_k^{(i)}, M_k^{(i)}(\sigma), D_k^{(i-1)}$. Initialiser $F^{(i)} = (F_k^{(i)}, k=1,...8N+2)$ à l'infini. En pratique on affecte une valeur assez élevée à $F_k^{(i)}, k=1,...8N+2$.
- pour k=7N+2,...2 (étape 302) où k correspond à un instant (indice de la transition) on effectue les opérations suivantes:

a) à partir de l'état du codeur après la k-ième transition dans le chemin décodé $\hat{\sigma}_k^{(i)}$ trouver l'état $\hat{\sigma}_{k-1}^{(i)}$) après la (k-1)-ième transition du chemin décodé et les 3 autres états précurseurs de $\hat{\sigma}_k^{(i)}$ c'est-à-dire $\sigma_{j,k-1}^{(i)}$, $j=1,2,3$ (étape 304). Pour cela, les valeurs de $\hat{\sigma}_k^{(i)}$ pour k variant de 1 à 8N+2, sont fournis par le décodeur de Viterbi tandis que $\sigma_{j,k-1}^{(i)}$ peuvent être stockés dans une mémoire.

A partir des métriques des états $\sigma_{1,k-1}^{(i)}$, $\sigma_{2,k-1}^{(i)}$, $\sigma_{3,k-1}^{(i)}$ et $\hat{\sigma}_k^{(i)}$ calculées et stockées dans le décodeur de Viterbi pour k = 1,... 7N+2, et qui sont notées:

$$M^{(i)}_{k-1}(\sigma^{(i)}_{1,k-1})$$
$$M^{(i)}_{k-1}(\sigma^{(i)}_{2,k-1})$$
$$M^{(i)}_{k-1}(\sigma^{(i)}_{3,k-1})$$
$$M^{(i)}_{k-1}(\overline{\sigma}^{(i)}_{k}).$$

on calcule les 3 métriques cumulées de l'état $\hat{\sigma}_k^{(i)}$ pour les 3 chemins provenant des 3 états $\sigma_{j,k-1}^{(i)}$, $j=1,2,3$. Ces trois métriques cumulées sont:

$$\delta(j)=M^{(i)}_{k-1}(\sigma^{(i)}_{1,k-1})+(I^{(i)}_{j,k}-D^{(i-1)}_{k})^2$$

si la transition de l'instant k-1 à l'instant k correspond à une perforation (k multiple de 7) et

$$\delta(j)=M^{(i)}_{k-1}(\sigma^{(i)}_{1,k-1})+(I^{(i)}_{j,k}-D^{(i-1)}_{k})^2+(D^{(i-1)}_{l_k}-R^{(i)}_{j,l_k})^2$$

s'il n'y a pas de perforation pour la transition de l'instant k-1 à l'instant k (étape 306).

Dans ces équations les symboles

$$D_k^{(i-1)}, D_{1_k}^{(i-1)}$$

sont les symboles reçus avant la i-ème itération correspondant aux symboles d'information et de redondance respectivement de la transition de l'instant (k-1) à l'instant k et les symboles

$$I_{j,k}^{(i)}, R_{j,1_k}^{(i)}$$

sont les symboles 4-AM d'information U1 et de redondance U2 respectivement affectés à la transition de l'état $\sigma_{j,k-1}^{(i)}$ à l'état $\hat{\sigma}_k^{(i)}$ (voir figure 6). Les symboles d' information et de redondance

$$I_{j,k}^{(i)}, R_{j,1_k}^{(i)}$$

affectés à la transition de l'état $\sigma_{j,k-1}^{(i)}$ à l'état $\hat{\sigma}_k^{(i)}$ sont stockés dans une mémoire au cours du décodage de Viterbi. L'indice $l_k$ est calculé seulement lorsqu'il n'y a pas de perforation (k multiple de 7) :

$$l_k = 7N + K/7.$$

c)- calculer la différence entre la métrique optimale et chacune des métriques cumulées:

$$\Delta(j)=\delta(j)-M^{(i)}_k(\sigma^{(i)}_k),$$

$j=1,2,3$ où $M^{(i)}_k(\hat{\sigma}^{(i)}_k)$ est la métrique optimale de l'état $\hat{\sigma}^{(i)}_k$.

Ensuite on examine les 3 survivants précurseur à l'état $\hat{\sigma}_k^{(i)}$. On remonte au survivant d'ordre j de $\hat{\sigma}_k^{(i)}$ vers $\sigma_{j,k-1}^{(i)}$. Puis on examine chaque survivant d'ordre j de l'état $\sigma_{j,k-1}^{(i)}$ jusqu'à l'état initial $\sigma=0$, ce qui consiste à faire varier l'indice de la transition de k à 1.

Pour réduire la complexité, on peut examiner les 3 survivants de l'état $\sigma_{j,k-1}^{(i)}$ jusqu'à l'état du survivant à l'instant k-L au lieu de l'instant 1, donc un nombre fixe de transitions. Pour L=10 la dégradation des performances est négligeable.

On compare le ou les symboles 4-AM affectés à la k'-ème transition du survivant d'ordre j au (aux) symbole(s)

décodé(s) $\hat{S}_{k'}^{(i)}$ et $\hat{S}_{7N+k'/7}^{(i)}$ pour k' variant de k jusqu'a 1 ou de k a (k-L) dans le second cas. S'ils sont adjacents (situés à une distance de 2) on calcule min $(\Delta(j), F_{k'}^{(i)})$ et on affecte ce minimum à $F_{k'}^{(i)}$ : soit

$$F_{k'}^{(i)} = \min(\Delta(j), F_{k'}^{(i)})$$

si le symbole $\hat{S}_{k'}^{(i)}$ et le symbole d'information affecté à la k'-ème transition du survivant j sont adjacents (étape 312). On fait de même pour $F_{7N+k'/7}^{(i)}$ pour k' multiple de 7 (pas de perforation), soit

$$F_{7N+k'/7}^{(i)} = \min(\Delta(j), F_{7N+k'/7}^{(i)})$$

si le symbole $\hat{S}_{7N+k'/7}^{(i)}$ est adjacent au symbole de redondance affecté à la k'-ème transition du survivant d'ordre j (étape 312).

d) On calcule la table des symboles $\tilde{S}_{k}^{(i)}$ adjacents à $\hat{S}_{k}^{(i)}$ correspondant au minimum, pour k variant de 1 à 8N+2, et, à chaque mise à jour de la fiabilité $F_{k'}^{(i)}$, on met à jour le symbole $\tilde{S}_{k'}^{(i)}$ en le remplaçant par le symbole 4-AM d'information relatif à la transition d'ordre k' du survivant j. De même pour le symbole $\tilde{S}_{7N+k'+k'/7}^{(i)}$ si k' est multiple de 7. A la fin on obtient les fiabilités $F_{k}^{(i)}$ du symbole décodé $\hat{S}_{k}^{(i)}$ ainsi que le symbole adjacent $\tilde{S}_{k}^{(i)}$ correspondant pour k=1,...8N+2 (étape 326).

Au cours de la quatrième étape, la fiabilité est ensuite normalisée pour permettre de calculer la décision douce $\tilde{D}_{k}^{(i)}$. Trois méthodes sont utilisables pour calculer la fiabilité normalisée $F_{k}^{norm(i)}$. On peut calculer:

$$\text{soit } F_{k}^{norm(i)} = F_{k}^{(i)} / \overline{F}$$

$$\text{soit } F_{k}^{norm(i)} = F_{k}^{(i)} + (1 - \overline{F})$$

$$\text{soit } F_{k}^{norm(i)} = (F_{k}^{(i)} / \beta_1) + \beta_2$$

où $\overline{F}$ est égale à la moyenne de $F_{k}^{(i)}$ calculée sur toute la matrice des fiabilités et $\beta_1$ et $\beta_2$ étant des constantes vérifiant $\overline{F} = \beta_1(1 - \beta_2)$.

Au cours de la cinquième étape, on calcule des décisions douces non pondérées (sous-ensemble 226). La décision douce $\tilde{D}_{k}^{(i)}$ est calculée à partir de la décision optimale $\hat{S}_{k}^{(i)}$ fournie par le décodeur de Viterbi, de sa fiabilité normalisée $F_{k}^{norm(i)}$ et de la séquence des symboles 4-AM $\tilde{S}_{k}^{(i)}$ fournie aux étapes 4 et 3 respectivement. Le symbole 4-AM est un symbole adjacent du symbole $\hat{S}_{k}^{(i)}$ c'est-à-dire que

$$|\tilde{S}_{k}^{(i)} - \hat{S}_{k}^{(i)}| = 2$$

et qui correspond au symbole 4-AM le plus probable après le symbole $\hat{S}_{k}^{(i)}$. Le symbole $\tilde{D}_{k}^{(i)}$ est donné par:

$$\tilde{D}_{k}^{(i)} = 1/2(\hat{S}_{k}^{(i)} + \tilde{S}_{k}^{(i)}) + sgn(\hat{S}_{k}^{(i)} - \tilde{S}_{k}^{(i)}) F_{k}^{norm(i)}$$

où la fonction sgn est définie par:

$$sgn(x) = \begin{pmatrix} 1 & si\ x>0 \\ 0 & si\ x=0 \\ -1 & si\ x<0 \end{pmatrix}.$$

Ainsi le symbole $\tilde{D}_{k}^{(i)}$ correspond à un symbole situé à la distance $F_{k}^{norm(i)}$ du seuil de décision entre $\hat{S}_{k}^{(i)}$ et $\tilde{S}_{k}^{(i)}$. Comme $E(F_{k}^{norm(i)}) = 1$, les symboles $\tilde{D}_{k}^{(i)}$ seront centrés autour des symboles 4-AM.

Pour améliorer les performances, au cours de la sixième étape, on pondère $\tilde{D}_{k}^{(i)}$ avec les symboles reçus après le canal $D_{k}^{(0)}$ qui sont conservés dans la mémoire 20 pour calculer $D_{k}^{(i)}$ :

$$D_{k}^{(i)} = \alpha_i \tilde{D}_{k}^{(i)} + (1-\alpha_i) D_{k}^{(0)}$$

où $\alpha_i$ est un coefficient de pondération. Par exemple: $\alpha_1 = 0,6$ ; $\alpha_2 = 0,9$ ; $\alpha_i = 1$ pour i supérieur à 2. Le but est de réduire l'effet de propagation d'erreurs durant les premières itérations. Les étapes 5 et 6 sont effectuées ensembles dans le sous-ensemble 226.

**Revendications**

1. Procédé de protection de données d'entrée mis en oeuvre dans un système de transmission numérique, le procédé comportant une phase de codage desdites données et une phase de décodage itératif, la phase de codage comportant une première étape de codage convolutif systématique en treillis permettant le décodage itératif combinée à une seconde étape d'attribution des données codées à des symboles d'une modulation numérique, caractérisé en ce que lors de la première étape le codage convolutif systématique en treillis présente un rendement de codage M/2M, où M est un entier supérieur à 1, le codage étant soumis à une perforation appliquée aux symboles pour obtenir un rendement de codage plus élevé, le code convolutif systématique perforé ainsi obtenu étant utilisé pour générer un code produit en blocs avec fermeture du treillis par ajout de données redondantes, le code produit étant formé de composantes générées par codage de lignes et de colonnes d'une matrice groupant les données codées par le code convolutif systématique perforé, la seconde étape combinant le code produit avec une modulation d'amplitude en quadrature à $2^{2M}$ états, le décodage itératif étant un décodage en blocs.

2. Procédé selon la revendication 1 caractérisé en ce que le codage convolutif systématique code deux bits d'entrée en quatre bits de sortie par combinaison linéaire.

3. Système de transmission numérique à protection de données d'entrée, comportant des moyens de codage desdites données et des moyens de décodage itératif, les moyens de codage comportant:

   - un premier sous-ensemble pour effectuer un codage convolutif systématique en treillis permettant le décodage itératif,
   - un second sous-ensemble pour attribuer les données codées à des symboles d'une modulation numérique, caractérisé en ce que le premier sous-ensemble met en oeuvre un codage convolutif systématique en treillis de rendement M/2M où M est un entier supérieur à 1 auquel il ajoute une perforation appliquée aux symboles pour obtenir un rendement de codage plus élevé, le code convolutif systématique perforé ainsi obtenu étant utilisé pour générer un code produit en blocs avec fermeture du treillis par ajout de données redondantes, le code produit étant formé de composantes générées par codage de lignes et de colonnes d'une matrice groupant les données codées par le code convolutif systématique perforé, le second sous-ensemble combinant le code produit avec une modulation d'amplitude en quadrature à $2^{2M}$ états, le décodage itératif étant un décodage en blocs.

4. Système selon la revendication 3 caractérisé en ce que les moyens de codage comportent des moyens, dits machine d'états, pour définir des états successifs du codeur et délivrer les symboles de redondance de fermeture du treillis.

5. Système selon la revendication 3 ou 4 caractérisé en ce que les moyens de codage convolutif systématique codent deux bits d'entrée en quatre bits de sortie en ajoutant deux bits de redondance, lesdits moyens comportant deux étages de cellules à décalage, les bits de sortie étant obtenus en combinant linéairement des données issues des cellules à décalage.

FIG.1

EP 0 848 524 A1

EP 0 848 524 A1

FIG. 2

FIG.3

16

FIG.4

EP 0 848 524 A1

FIG.5

FIG. 6

FIG.7

FIG.8

300

$$k = 1, \ldots 8N+2$$
$$\hat{S}_k^{(i)}, \ M_k^{(i)}(\sigma)$$
$$D_k^{(i-1)}$$

301 $\quad F_k^{(i)}$

302 $\quad k = 7N+2$

304 $\quad \hat{G}_{j,k-1}^{(i)}, j = 1,2,3$

306 $\quad \delta(j), j = 1,2,3$

308 $\quad j = 1$

310 $\quad k' = k$

312 $\quad F_{k'}^{(i)}, \ \tilde{S}_{k'}^{(i)}$

314 $\quad k' = k-1$

316 $\quad k' = 0$ — N / Y

318 $\quad j = j+1$

320 $\quad j = 4$ — N / Y

322 $\quad k = k-1$

324 $\quad k = 1$ — N / Y

326 $\quad F_k^{(i)} \ \tilde{S}_k^{(i)}$

FIG.9

21

**Office européen des brevets**

## RAPPORT DE RECHERCHE EUROPEENNE

Numéro de la demande

EP 97 20 3747

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | GOFF ET AL.: "Turbo-codes and high spectral efficiency modulation" SUPERCOM/ICC 1994, 1 - 5 mai 1994, NEW YORK, US, pages 645-649, XP000438590 * abrégé * * page 645, colonne de gauche, alinéa 4 * * page 646, colonne de gauche, alinéa 1 - alinéa 2; figure 3 * --- | 1-5 | H04L27/34 |
| A | KIM, POTTIE: "On punctured trellis coded modulation" ICC 1995, 18 - 22 juin 1995, NEW YORK, US, pages 678-682, XP000533100 * abrégé * * page 678, colonne de droite, alinéa 2 * --- | 1-5 | |
| A | CREMONESI ET AL.: "An adjustable-rate multilevel coded modulation system: analysis and implementation" EUROPEAN TRANSACTIONS ON TELECOMMUNICATIONS AND RELATED TECHNOLOGIES., vol. 4, no. 3, mai 1993, MILANO IT, pages 277-283, XP000385754 * page 277, colonne de gauche, alinéa 2 - colonne de droite, alinéa 1 * * page 278, colonne de droite, alinéa 1 * * page 278, colonne de droite, alinéa 3 * --- | 1-5 | **DOMAINES TECHNIQUES RECHERCHES (Int.Cl.6)** H04L H03M |
| A | EP 0 624 019 A (GENERAL INSTRUMENT CORPORATION) 9 novembre 1994 * abrégé * * page 3, ligne 18 - ligne 31 * --- -/-- | 1-5 | |

Le présent rapport a été établi pour toutes les revendications

| Lieu de la recherche | Date d'achèvement de la recherche | Examinateur |
|---|---|---|
| LA HAYE | 20 mars 1998 | Scriven, P |

**Office européen**
**des brevets**

# RAPPORT DE RECHERCHE EUROPEENNE

Numéro de la demande

EP 97 20 3747

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 408 502 A (HOW) 18 avril 1995 <br> * abrégé * <br> * colonne 3, ligne 36 - ligne 40 * <br> --- | 1-5 | |
| A | JUNG-FU CHENG ET AL.: "Complexity-reduced multilevel coding with rate-compatible punctured convolutional codes" <br> GLOBECOM 1993, <br> 29 novembre 1993 - 2 décembre 1993, NEW YORK, US, <br> pages 814-818, XP000427922 <br> * page 814, colonne de gauche, alinéa 3 - colonne de droite, alinéa 1 * <br> ----- | 1-5 | |

**DOMAINES TECHNIQUES RECHERCHES (Int.Cl.6)**

Le présent rapport a été établi pour toutes les revendications

| Lieu de la recherche | Date d'achèvement de la recherche | Examinateur |
|---|---|---|
| LA HAYE | 20 mars 1998 | Scriven, P |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
 
& : membre de la même famille, document correspondant

EPO FORM 1503 03 82 (P04C02)